# EUROPÄISCHE PATENTANMELDUNG

(11) **EP 2 952 827 A1**
(43) Veröffentlichungstag der Anmeldung: **09.12.2015**
(21) Anmeldenummer: 15450021.9
(22) Anmeldetag: 08.05.2015
(51) Int. Cl.: F24J 2/52

(54) **GEHÄUSE FÜR PHOTOVOLTAIKGERÄT**

(30) Priorität: 04.06.2014 AT 4362014
(71) Anmelder: Tappeiner, Roland, 1170 Wien (AT)
(72) Erfinder: Tappeiner, Roland, 1170 Wien (AT)

(57) **Zusammenfassung**

Gehäuse für ein Photovoltaikgerät, bestehend aus zwei dreieckigen Seitenteilen (2,3), einem Boden (11), einer Rückwand (10) und einem Photovoltaikpaneel (1) welche in Nuten (21,22,23) der Seitenteile (2,3)geschoben werden und mittels dreier Stangen (4, 5, 6) zusammengehalten werden.

## Beschreibung

Die Erfindung betrifft ein Gehäuse für ein mobiles und tragbares Photovoltaikgerät.

Photovoltaische Zellen, auch Solarzellen genannt, werden üblicherweise von einem Rahmen umgeben, der aus einem Aluminiumprofil gefertigt ist. Sie bilden mit diesen Rahmen einen Solarmodul.

Auf der Unterseite des Solarmoduls befindet sich zwar ein Gehäuse das auch elektronische Bauteile beinhalten kann, es ist jedoch immer kleiner als das Modul selbst.

Ziel der Erfindung ist es, ein Gehäuse zu entwickeln, das ähnlich wie ein Rahmen, die Solarzellen schützt, jedoch so groß ausgelegt ist, dass im inneren des Gehäuses Platz für elektronische Geräte vorhanden ist.

Das Gehäuse sollte einen Tragegriff aufweisen und die optimale Ausrichtung der Solarzellen gewährleisten.

Es sollte einfach herzustellen sein und auch von einem Nichtfachmann zusammenzubauen sein.

Als Beispiel für das elektronische Gerät, das im Gehäuse untergebracht werden soll, wird eine Solarsteckdose mit einem Akku, einem Laderegler und einem 12Volt/ 230Volt Inverter verwendet.

Im Gehäuse könnte aber auch ein WIFI Hotspot oder eine Pumpe untergebracht sein.

### Stand der Technik

Solarmodule werden üblicherweise mit einem Rahmen aus Aluminium geliefert. Im Dokument US2014076399 wird ein solcher Rahmen gezeigt. Solche Rahmen bilden jedoch kein geschlossenes Gehäuse in dem elektronische Komponenten untergebracht sind.

Photovoltailgeräte mit einem Photovoltaikpaneel, elektronischen Komponenten und einer Batterie sind aus JP2002238183 bekannt. Weiters ist ein Gerät von Xantrex Technologies (852-2071 Xpower) bekannt das Kofferförmig gebaut ist.

Aus EP1104029 ist bekannt, dass Photovoltaikpaneele auf einer Struktur montiert werden können deren Querschnitt ein rechtwinkeliges Dreieck bildet.

US-A-2007/0278989 offenbart ein solar betriebenes Netzteil das ein Gehäuse mit dreieckigen Seitenteilen, einen Boden, eine Rückwand und eine Vorderwand aufweist, wobei an der Vorderwand ein Solarpaneel angebracht ist und im inneren des Gehäuses sich eine Batterie und ein Laderegler befindet.

Als nächstliegender Stand der Technik wird die modulare Solarsteckdose, so wie in AT511567 offenbart, angesehen.

In AT511567 wird jedoch nicht auf den Zusammenbau des Gehäuses eingegangen, noch werden Details des Gehäuses offenbart.

### Aufgabe der Erfindung

Die technische Aufgabe der Erfindung ist es ein tragbares Gehäuse für ein Photovoltaikgerät zu entwickeln, das auch von einem Nichtfachmann zusammengebaut werden kann. Es sollte kompakt, stabil und einfach im Zusammenbau sein.

Eine weitere Aufgabe ist es ein Verfahren für den Zusammenbau bereitzustellen das mit einem Minimum an Werkzeugen und Fachkenntnis auskommt.

### Ausführung der Erfindung

Das Gehäuse der vorliegenden Erfindung besteht aus zwei gegenüberliegenden dreieckigen Seitenwänden, einer Vorderwand, einer Rückwand und einem Boden. Die beiden Seitenwände sind mittels dreier Stangen miteinander verbunden.

In den Seitenwänden befinden sich jeweils drei Nuten.

In diesen Nuten befinden sich die Vorderwand bzw. das Photovoltaikpaneel, die Rückwand und der Boden. Somit bilden die zwei Seitenwände zusammen mit der Rückwand und dem Boden ein geschlossenes Gehäuse das von den drei Stangen zusammengehalten wird.

Die Stangen können sowohl innerhalb des Gehäuses als auch außerhalb des Gehäuses angebracht sein.

Entweder wird an den Enden der Stangen ein Innengewinde angebracht und die Seitenteile werden mittels Schrauben mit den Stangen verbunden, oder es befindet sich ein Außengewinde an den Enden der Stangen. Das Außengewinde ragt dann durch die Seitenteile, die dann mittels Hutmuttern an den Stangen befestigt werden.

Die Erfindung wird anhand eines Ausführungsbeispiels gemäß den Zeichnungen näher erläutert, wobei
Fig. 1 das Gehäuse von links vorne zeigt;
Fig. 2 das Gehäuse von rechts vorne ohne Vorderwand zeigt;
Fig. 3 das Gehäuse von hinten zeigt und
Fig. 4 die rechte innere Seitenwand in Draufsicht und im Querschnitt zeigt.

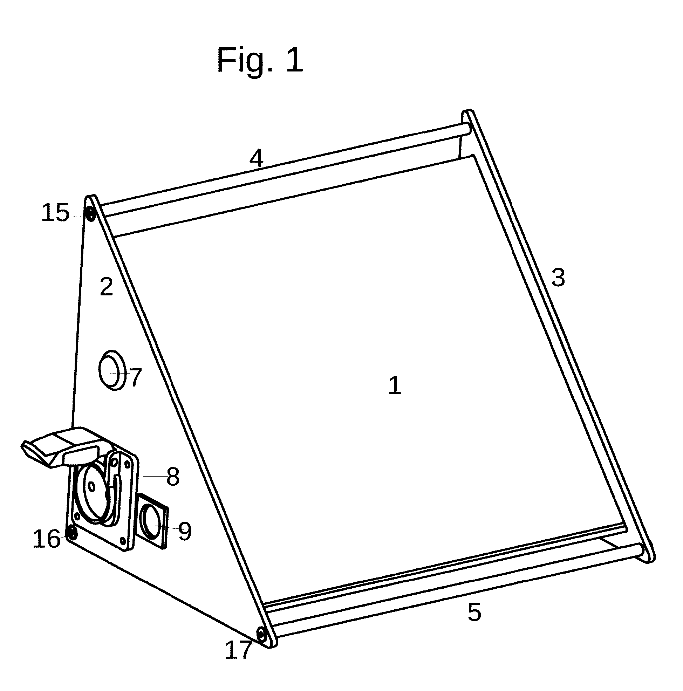

Das Ausführungsbeispiel zeigt die Verwendung des Gehäuses als Solarsteckdose. Fig. 1 zeigt das Potovoltaikpaneel 1, das linke Seitenteil 2 und das rechte Seitenteil 3. Die beiden Seitenteile 2 und 3 werden mittels Stangen 4, 5 und 6 Zusammengehalten.

An den Enden der Stangen 4, 5 und 6 befindet sich ein Innengewinde. Mittels Schrauben 15, 16 und 17 wird das linke Seitenteil 2 mit den Stangen 4, 5 und 6 verbunden.

Im linken Seitenteil 2 ist eine 230 Volt Steckdose 8 mit Deckel angebracht. Über der Steckdose ist ein Schalter 7 angebracht mit dem Steckdose ein und ausgeschaltet werden kann.

Neben der 230 Volt Steckdose befindet sich eine 12 Volt Steckdose 9 wie sie üblicherweise in Fahrzeugen für den Zigarettenanzünder verwendet wird.

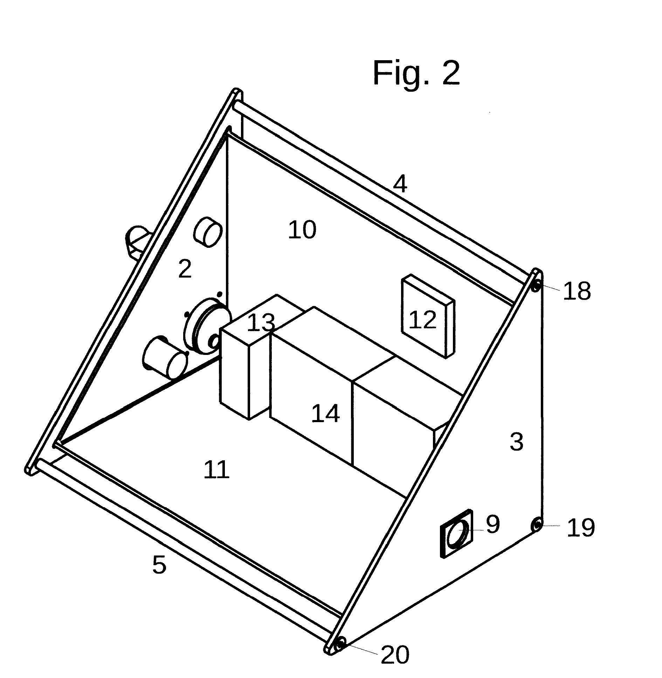

Fig. 2 ist eine Darstellung des Gehäuses ohne Photovoltaikpaneel, sodass das innere des Gehäuses sichtbar ist. Das rechte Seitenteil 3 wird mittels Schrauben 18, 19 und 20 mit den Stangen 4, 5 und 6 verbunden. Der Boden 10 und die Rückwand 11 sind mittels der Stangen 4, 5 und 6 mit den Seitenteilen 2 und 3 verbunden. Im inneren des Gehäuses befindet sich ein Laderegler 12. Er kann direkt im Anschlussgehäuses des Photovoltaikpaneels angebracht sein. Der Laderegler 12 ist mit einem oder mehreren Akkus 14 verbunden. Über einen Schalter 7 ist ein Wechselrichter 13 angeschlossen dessen Ausgang mit der 230 Volt Steckdose 8 verbunden ist.

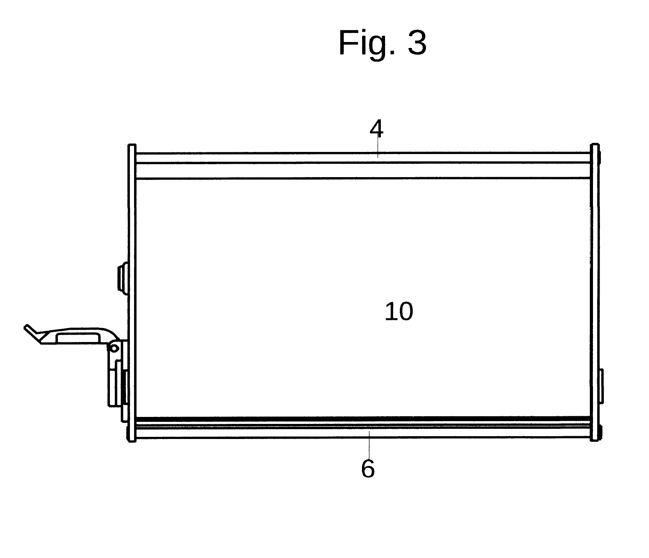

Fig. 3 zeigt das Gehäuse von hinten. Es ist die Rückwand 10, die obere Stange 4 und die untere Stange 6 ersichtlich.

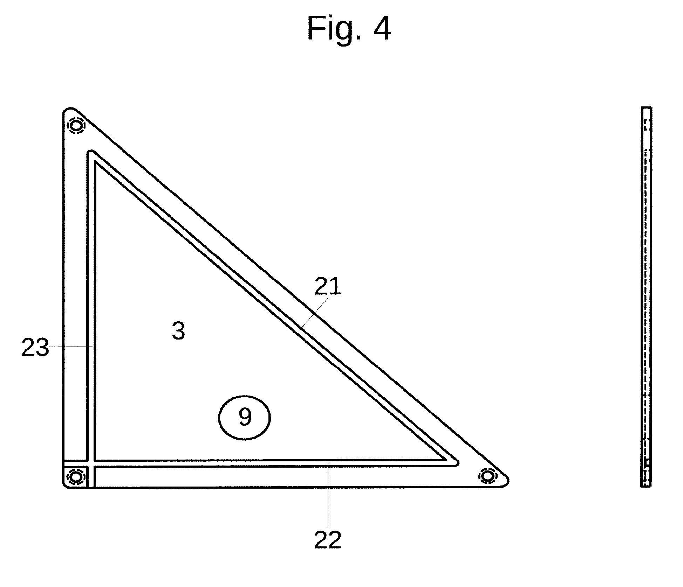

Fig. 4 zeigt das Seitenteil 3 von der Innenseite.

Es sind die Nuten 21, 22 und 23 erkennbar.

Damit die Rückwand 11 und der Boden 10 eingeschoben werden können ist die Nut bis zum Rande herausgeführt. Das Seitenteil 2 (in den Zeichnungen nicht dargestellt) hat ebenfalls 3 Nuten, worin das Photovoltaikpaneel 1, der Boden 10 und die Rückwand 11 ebenfalls eingeschoben werden.

Das Photovoltaikpaneel 1 wird als erstes in die Nut eines Seitenteils geschoben und dann in die Nut des anderen Seitenteils. Dann werden die beiden Seitenteile 2 und 3 mittels der Stangen 4, 5 und 6 und den Schrauben 15, 16, 17, 18, 19 und 20 miteinander verbunden, sodass das Photovoltaikpaneel fest in die Nuten gedrückt wird.

Es ist also eine stabile Struktur entstanden in die dann der Boden geschoben werden kann. Bevor die Rückwand eingeschoben wird, werden die Komponenten im inneren des Gehäuses angebracht und verdrahtet.

Der Boden 11, sowie auch die Rückwand 10, können gleichzeitig in die Nuten des rechten und linken Seitenteils geschoben werden.

## Patentansprüche

1. Gehäuse für ein Photovoltaikgerät wobei das Gehäuse aus zwei gegenüberliegenden dreieckigen Seitenwänden (2,3) besteht, die durch eine Vorderwand (1), eine Rückwand (10)und einen Boden (11) miteinander verbunden sind und somit ein geschlossenes Gehäuse bilden das elektronische Geräte und Akkumulatoren einschließt und auf deren Vorderseite sich ein Photovoltaikpaneel (1) befindet, wobei das Photovoltaikpaneel (1) entweder die Vorderwand (1) bildet oder an dieser angebracht ist und durch seine Lage optimal zur Sonne hin ausgerichtet ist, **dadurch gekennzeichnet, dass** die beiden Seitenteile (2,3) jeweils drei Nuten (21, 22, 23) aufweisen in denen der Rand der Rückwand (10), der Rand des Bodens (11) und der Vorderwand (1) aufgenommen sind und die beiden Seitenteile (2,3) mittels dreier Stangen (4, 5, 6) zusammengehalten werden.

2. Gehäuse für ein Photovoltaikgerät nach Anspruch 1, **dadurch gekennzeichnet dass** an den Enden der drei Stangen (4, 5, 6) sich ein Gewinde befindet auf das eine Mutter geschraubt werden kann um die Stangen mit den beiden Seitenteilen zu verbinden.

3. Gehäuse für ein Photovoltaikgerät nach Anspruch 1, **dadurch gekennzeichnet dass** an beiden Enden der drei Stangen (4, 5, 6) sich ein Innengewinde befindet um daran die beiden Seitenteile mittels Schrauben (15, 16, 17, 18, 19, 20) zu befestigen.

4. Gehäuse für ein Photovoltaikgerät nach Anspruch 1 bis 3, **dadurch gekennzeichnet dass** die Stangen (4, 5, 6) sich innerhalb des Gehäuses befinden.

5. Gehäuse für ein Photovoltaikgerät nach Anspruch 1 bis 3, **dadurch gekennzeichnet dass** die Stangen(4, 5, 6) sich außerhalb des Gehäuses befinden.

6. Gehäuse für ein Photovoltaikgerät nach einem der Ansprüche 1 bis 5, **dadurch gekennzeichnet dass** an einem der Seitenteile eine 230 Volt Steckdose, und eine 12 Volt Fahrzeugsteckdose angebracht ist.

7. Gehäuse für ein Photovoltaikgerät nach einem der Ansprüche 1 bis 6, **dadurch gekennzeichnet dass** an beiden Seitenteilen eine 12 Volt Fahrzeugsteckdose angebracht ist.

8. Verfahren zum Zusammenbau eines Gehäuses nach Anspruch 2, **dadurch gekennzeichnet dass** erst die Vorderwand (1) in die entsprechende Nut des ersten Seitenteils eingeschoben wird, dann das zweite Seitenteil angebracht wird und mittels der 3 Stangen (4, 5, 6) und den Muttern befestigt, sodass die Vorderwand fest in den Nuten der Seitenteile sitzt.

9. Verfahren zum Zusammenbau eines Gehäuses nach Anspruch 3, **dadurch gekennzeichnet dass** erst die Vorderwand (1) in die entsprechende Nut des ersten Seitenteils eingeschoben wird, dann das zweite Seitenteil angebracht wird und mittels der 3 Stangen (4, 5, 6) und den Schrauben (15, 16, 17, 18, 19, 20) befestigt, sodass die Vorderwand fest in den Nuten der Seitenteile sitzt.

10. Verfahren zum Zusammenbau eines Gehäuses nach Anspruch 8 oder 9, **dadurch gekennzeichnet dass** erst der Boden (11) in die beiden Nuten der Seitenteile (2, 3) geschoben wird und dann die Komponenten im inneren des Gehäuses angebracht werden, um dann das Gehäuse mittels Einschub der Rückwand (10) zu schließen.
